# EUROPEAN PATENT APPLICATION

(11) **EP 0 547 251 A1**
(43) Date of publication of application: **23.06.1993**
(21) Application number: 91121467.4
(22) Date of filing: 14.12.1991
(51) Int. Cl.: G01R 31/28, G01R 1/073

(54) **A method for testing a micro circuit**

(71) Applicant: International Business Machines Corporation, Armonk, N.Y. 10504 (US)
(72) Inventor: Metzger, Roland, W-7251 Wimsheim (DE); Schmidt, Manfred, W-7036 Schönaich (DE); Torreiter, Otto, W-7022 Leinfelden Echterdingen (DE); Wendel, Dieter, W-7032 Sindelfingen (DE)
(74) Representative: Schäfer, Wolfgang, Dipl.-Ing.

(57) **Abstract**

The invention provides for a iterative method of testing a micro circuit such as an integrated circuit on a wafer or on a printed circuit board, the micro circuit having a plurality of contact pads. The inventive method comprises the following steps:
a) Moving (1) of a test head or the contact pads towards each other for a first distance (Δz1) being smaller than a predefined maximum length (Δzmax), the test head incorporating a plurality of probes, each probe serving to contact one of said pads;
b) performing an electrical test (2) of said micro circuit via the probes of said test head;
c) if said test shows a certain result:
   α) further moving (4) of said test head of said contact pad towards each other;
   β) performing said test of step b) again (5);
   δ) if said certain result is still shown: repeating step cα) and step cβ) until
      I. said certain result is no longer shown; or
      II. said predefined maximum length is reached.

The invention also provides for a test-system for carrying out the inventive method.

## Description

The invention relates to a method for testing a micro circuit, such as an integrated circuit on a wafer or on a printed circuit board, via a test head incorporating a plurality of probes. Further the invention relates to a test system for testing a micro circuit.

In general, micro circuits such as integrated circuits are fabricated from thin semiconductor slices - often called wafers - having a plurality of micro circuits thereon. Customarily each wafer contains a multiple of identical repeating matrices of the same type of micro circuit. Before final processing and encapsulation, it is customary to test each of the micro circuits on a wafer prior to separating the wafer into desired individual micro circuits by dicing of the wafer. Since each micro circuit of a wafer is normally positioned in a predetermined precise relation with respect to adjacent circuit units, it is possible to automatically test each individual micro circuit. A plurality of probes has to be accurately located on each preselected contact pad of the micro circuit to be tested on the wafer. Normally, testing is performed by injecting signals and collecting test data from the micro circuit via the probes.

In the test procedure there are several obstacles to overcome in order to have reliable testing. Since the relative heights of the contact pads of a micro circuit on a wafer can vary substantially in magnitude, testing probes having electrodes with mechanically flexible characteristics have been employed in the prior art in order to accurately contact the pads. Where the micro circuit pads have a substantial dimensional tolerance in the relative height thereof with respect to the surface of the wafer, the resiliency of the probes being incorporated in a test head is to compensate for such variation.

However, the problem arises that the resiliency of the probes may not be sufficient to compensate this dimensional tolerance of the pads, since the probes themselves also have a tolerance in length relatively to the test head. In the case that a relatively short probe is to contact a relatively flat pad there might therefore be an open between the probe and the pad. Since it is not possible to distinguish a real open in the micro circuit which is to be tested and a pseudo open between probe and pad, the result of the test procedure may be erroneous so that an actually good micro circuit is considered to be not operational. Obviously this results in a loss of circuit yield. Test systems of this kind have been proposed for example in IBM Technical Disclosure Bulletin, Volume 22, No. 7, December 1979, pages 2824 to 2826, IBM Technical Disclosure Bulletin, Volume 26, No. 1, June 1983, page 251, EP-B-0 130 350, EP-A-0 331 163, EP-A-0,256,541 and EP-A-0 343 021 wherein different resilient probe constructions are shown.

In order to improve the reliability of testing, flexible probes are described in US-A-4 951 370 having a piezoelectric member. In operation an electrical signal is produced by the piezoelectric member when sufficient force is imparted to the probe tip to cause corresponding flexing of the piezoelectric member. This signal serves to indicate whether mechanical contact of probe and pad is made. This control signal is also used according to the teaching of this document for a technique called scrub-in: After the probe tips make contact with the pads, it is necessary for the wafer-holder to move an additional distance of over travel towards the probes in order to break through the oxide layer on the pads and make good electrical contact with the micro circuit. However special piezoelectric probes have to be employed according to the teaching of this document and no solution to the above described problem is provided, when a relatively short probe is to contact a relatively flat pad so that an open in the micro circuit is indicated where in reality none exists.

Therefore it is an object of the invention to increase the reliability of micro circuit testing.

The inventive solution of said object resides, as set forth in the claims, in a method for testing a micro circuit, such as an integrated circuit on a wafer or on a printed circuit board, the micro circuit having a plurality of contact pads, including the following steps:
a) Moving of a test head or the contact pads towards each other for a first distance being smaller than a predefined maximum length, the test head incorporating a plurality of probes, each probe serving to contact one of said pads;
b) performing an electrical test of said micro circuit via the probes of said test head;
c) if said test shows a certain result:
   α) further moving of said test head or said contact pads towards each other,
   β) performing said test of step b) again,
   δ) if said certain result is still shown: repeating step cα) and step cβ) until
      I. said certain result is no longer shown, or
      II. said predefined maximum length is reached.

In particular the invention provides for a test system to perform the inventive method.

The inventive solution takes advantage of the fact that ordinary contact pads, such as C4-balls, can be deformed relatively easily due to their material properties. Normally, no heating of the wafer is necessary in order to plastically deform the contact pads.

If an electrical test which is carried out on a micro circuit shows a certain result, such as an open in the micro circuit, this can be due to a real open in the circuit. However, this can also be due to a pseudo open between a probe of the test head and the corresponding pad. The electrical test of the micro circuits can only be carried out correctly if all electrical contacts between the probes and the corresponding pads are made correctly. In most cases all contacts are made correctly if the test head is moved from its starting position towards the contact pads for a certain distance in order to press the probes, which can be made of a resilient material, against the contact pads, so that the oxide layer on the pads is broken through. There is however a statistical probability that a relatively short probe is to contact a flat pad having a relatively small vertical extension, because of tolerances of the probes and the pads. In this case all contacts are made correctly with the exception of the above described probe-pad pair. Thus, the electrical test of the micro circuit will show the result "open". There is no possibility to determine in prior art test systems whether an "open" is a real open in the circuit or a pseudo open. Consequently, in prior art test systems this result "open" is always interpreted as an open in the micro circuit and consequently a good micro circuit is possibly considered to be defective resulting in a decrease of circuit yield.

The inventive solution overcomes this prior art drawback by deforming the contact pads which are already in mechanical contact with their corresponding probes. This is done by further moving of the test head towards the contact pads or vice versa depending on the mechanical construction of the test system which is employed. By this further motion an increased pressure is applied to the pads which already have been contacted before. Thereby these pads are deformed so that the probe-pad pair, which has not been made contact yet also comes closer. If the electrical test which is performed again shows the same result "open", this operation is repeated deforming more and more the contact pads which are already in contact with the probes. If after a number of repetitions of this procedure there is still the same result of the test and the test head or the probes respectively, have been moved for a predefined maximum length towards each other, the micro circuit is considered to be really defective.

Preferably, before each repetition of the electrical test, the test head or the probes are made to move or vibrate relatively to each other in a plane being substantially parallel to a plane comprising the pads of the micro circuit. This step of moving or vibrating is carried out so that a certain curve form is circumscribed by the test head or the pads, respectively. The curve form to be circumscribed can be e.g. a straight line, a circle or an ellipse. Further, the above described step of moving or vibrating is preferably carried out with a predefined amplitude being approximately half the pads' diameter. This serves to apply shearing forces to the pads, so that further plastical deformation of the pads takes place. Alternatively, the probes can be made to vibrate by an ultrasonic sound source in order to deform the pads. Preferably, the frequency of the ultrasonic sound source is chosen to correspond approximately to a resonant frequency of the probes.

Wafers incorporating micro circuits normally have a surface warpage. The inventive method also provides for a compensation of the detrimental effect of this surface warpage by the above described adaptive deformation of the pads. It is a further advantage of the invention, that a test system which is operated according to the teaching of the invention undergoes less mechanical stressing. This is due to the fact that firstly the test head or the pads are moved towards each other for a distance being smaller than a predefined maximum length. The maximum length corresponding to a maximum pressure to be exerted on the probes and the test head is only reached in rare cases. During the test procedure the pads which are in mechanical contact with the corresponding pads are plastically deformed in each repetition of the test loop so that they become flatter. Thus, the pressure which is exerted on the pads does not increase linearly when the test head comes nearer. Therefore the maximum length can be longer - or with other words - the minimum distance between the test head and the pads can be shorter without exceeding the maximum allowable pressure in an inventive test system than in prior art test systems. The iterative procedure of the invention makes it possible to start with a smaller length corresponding to relatively low pressure.

An advantageous embodiment of the invention is subsequently described in connection with the drawing in which:
- Fig. 1: is a diagram of the set-up of a test-system according to the invention;
- Fig. 2: is a perspective view revealing schematically a construction of the probe station of the inventive test-system;
- Fig. 3a, b, c: is a magnified schematic view of probes and corresponding pads belonging to a chip on a wafer to be tested depicting the iterative deformation of some of the pads;
- Fig. 4: is a flow-chart showing one advantageous way of carrying out the inventive method;
- Fig. 5: is a magnified view of the pads on a wafer after testing with the inventive test-system.

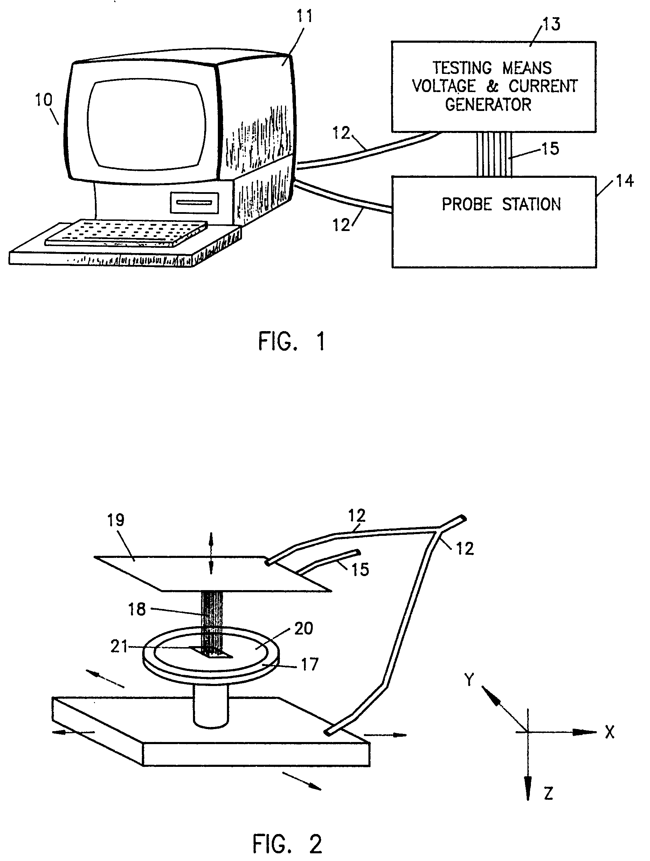

Referring to the drawing and particularly Fig. 1, there is shown a diagram of a test-system 10. The test-system includes a controller 11, typically a desk top computer, interfacing electrical bus 12, testing means 13 for generating and sensing voltage and measurement currents, which are bussed to a probe station 14 through an electrical bus 15 and connected to a test head 19 shown in Fig. 2. The controller 11 controls the movement of a wafer holder 17 at the probe station 14 and the movement of the test head 19, which incorporates a matrix of probes 18. Further the controller 11 controls the testing means 13, so that appropriate currents or voltages are applied to selected probes 18 and the response currents or voltages are measured with the testing means including an appropriate program or system of linked programs.

Fig. 2 shows the probe station in more detail. The station is made up of a wafer holder 17 and a test head 19 incorporating a matrix of probes 18. The wafer holder 17 is movable in the xy plane whereas the test head 19 is movable along the z-direction by positioning means, preferably comprising stepper motors, which are not shown in the drawing.

When the semiconductor wafer 20 is mounted on the wafer holder 17 the test-system utilizes the degrees of freedom provided to bring the probes 18 of the test head 19 and pads 22 on chip 21 fabricated on wafer 20 into alignment.

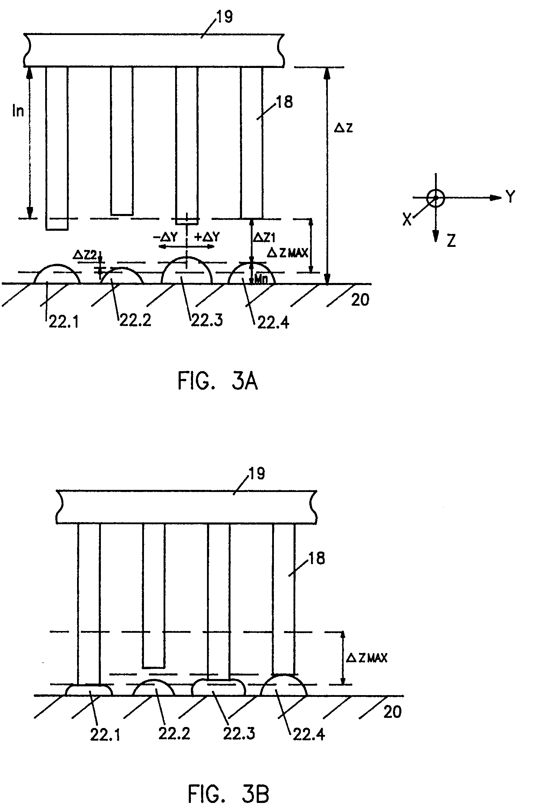

With reference to Fig. 3a now, there are shown probes 18 which are to be brought into contact with pads 22. In this advantageous embodiment of the invention the probes 18 are so-called cobra probes which are commonly used in the art and described for example in IBM Technical Disclosure Bulletin, Volume 26, No. 1, June 1983, page 251. The probes' diameter in this case is about 0.100 mm. In this example of carrying out the invention, the pads 22 are realized as C4-balls having a diameter of about 0.150 mm. The technology of controlled collapse chip connection (C4) is widely used in the art and described for example in "Microelectronics Packaging Handbook" by Tummala and Rymaszewski, Van Nostrand Reinhold, New York, 1989, chapter 6.3, pages 366 to 391. The C4-balls 22 shown in the drawing belong to chip 21 which is fabricated on wafer 20. The number of C4-balls 22 belonging to one chip is currently in the order of several hundreds, especially 300 to 600 and is likely to increase with the advance of chip technology. It is also shown in Fig. 3a that the length of the probes and the magnitude of the pads are having tolerances, thus generally not being exactly the nominal length lₙ and nominal magnitude Mₙ, respectively.

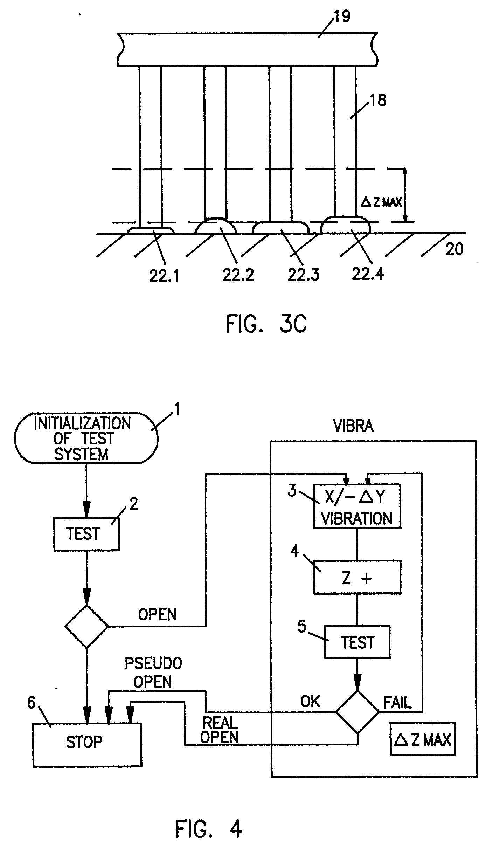

With reference to Fig. 4, a preferred embodiment of the inventive method is described in greater detail. In a step 1 of initialization of the test-system, the test head is moved from a defined starting position, which is a distance Δz above the wafer holder 17 as shown in Fig. 3 for a first distance Δz1 towards the contact pads 22. The first distance Δz1 is smaller than a predefined maximum length Δzmax. The maximum length Δzmax should not be exceeded to prevent damage from the system.

In a step 2 an electrical test of the chip 21 is performed by the testing means 13 via the probes. Since in this example there are still opens between several probes 18 and corresponding pads 22 after performing step 1 because of tolerances (cf. Fig. 3a, pad 22.2), the test shows the result "open". This initializes the subroutine VIBRA comprising steps 3, 4 and 5. In step 3 the controller 11 controls the stepper motors of wafer holder 17 so that the pads on the wafer are moved once or several times back and forth for a length -Δy and +Δy in the y-direction in order to plastically deform those pads (22.1, 22.3) which are already mechanically pressed against the probes. The result of this deformation is schematically shown in Fig. 3b.

In a step 4 the controller 11 controls the stepper motor of the test head to move the test head an additional smaller distance Δz2 towards the pads 22. In step 5 the electrical test is performed again. Steps 3, 4 and 5 are repeated as long as the test in step 5 shows the same results ("open"), thereby bringing the test head 19 closer and closer to the pads. Preferably Δz2 is decremented for a small value after each repetition. If after several repetitions all probe-pad contacts are properly made and the chip 21 is good, the test in step 5 will show the result "o.k.". Thereby it is clear that the initial open detected in step 2 is not a real one in the chip 21, but a pseudo open between at least one probe 18 and one pad 22. The final result of the above described iterative deformation is shown in Fig. 3c

If after several repetitions of steps 3, 4 and 5 the maximum length Δzmax is reached and the test of step 5 still shows the same result ("open"), the open is considered to be in the chip and not caused by a bad contact between a probe and the pad.

In the case that all contacts are properly made in step 1 and the test shows the result "o.k." or "good chip" the testing of the chip 22 at this stage of the chip production is terminated and the system can proceed to another chip 22 being adjacent the first chip 22 on the same wafer 17 starting the testing with step 1 again.

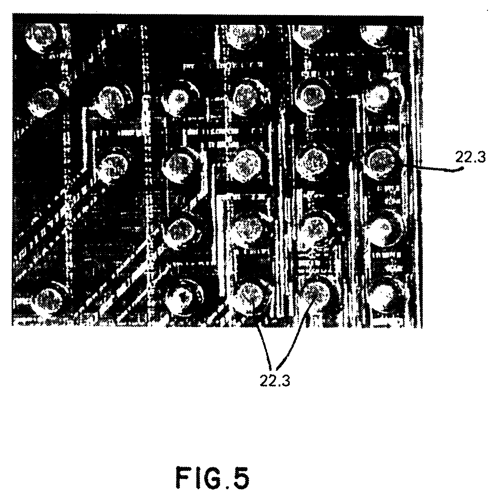

Fig. 5 reveals a magnified view of the pads on the wafer after testing is performed according to the inventive testing method. It can be seen that in this specific example significant deformation of some of the contact pads 22 has taken place (cf. pads 22.3). This is due to the repetition of steps 3 and 4 resulting in a compensation of the tolerances of the magnitude of the pads 22 and the probes 18. The deformation is reversible by a "re-flow" or heating of the C4-balls above the melting point.

Despite the fact, that the above described preferred embodiment of the invention refers to wafer testing, the invention is not restricted to this. In particular the invention can also be employed for testing of printed circuit boards or the like, since for example on printed circuit boards there is also a big number of contacts to be made properly for testing purposes.

## Claims

1. A method for testing a micro circuit (21), such as an integrated circuit on a wafer or on a printed circuit board, the micro circuit having a plurality of contact pads (22), including the following steps:
a) moving (1) of a test head (19) or the contact pads (22) towards each other for a first distance (Δz1) being smaller than a predefined maximum length (Δzmax), the test head incorporating a plurality of probes (18), each probe serving to contact one of said pads;
b) performing an electrical test (2) of said micro circuit (22) via the probes of said test head;
c) if said test shows a certain result:
α) further moving (4) of said test head or said contact pads towards each other;
β) performing said test of step b) again (5);
δ) if said certain result is still shown: repeating step cα) and step cβ) until
I. said certain result is no longer shown, or
II. said predefined maximum length is reached.

2. The method for testing a micro circuit according to claim 1, whereby said further motion of said test head or said pads in step cα) is carried out for a second predefined length (Δz2).

3. The method for testing a micro circuit according to any one of the preceding claims, whereby said second predefined length is decremented during the repetition of steps cα) and cβ) in step cδ).

4. The method for testing a micro circuit according to any one of the preceding claims, whereby said test head or said pads are made to move or vibrate (3) in a plane being substantially parallel to a plane comprising the pads of the micro circuit, preferably before performing said test in step cβ).

5. The method for testing a micro circuit according to claim 4, whereby said moving or vibrating of the test head or the pads is carried out with a predefined amplitude (±Δy), the amplitude being approximately half the pads' diameter.

6. The method for testing a micro circuit according to any one of the preceding claims, whereby said probes are made to vibrate by an ultrasonic sound source, the frequency of said sound source preferably corresponding approximately to a resonant frequency of the probes.

7. The method for testing a micro circuit according to any one of the preceding claims, whereby if said test performed in step b) shows not a certain result, or if said certain result is no longer shown in step cδ), said micro circuit is considered to be operable,
or if said predefined maximum length is reached in step cδ) and said certain result is still shown, said micro circuit is considered to be defective.

8. The method for testing a micro circuit according to claim 7, whereby it is stored in a data processing system whether the micro circuit is considered to be defective or not.

9. A method for testing a wafer incorporating a plurality of micro circuits (21), such as integrated circuits, characterized in that each micro circuit of said plurality of micro circuits is tested according to the method of any one of the preceding claims.

10. A test-system for testing a micro circuit (21), such as an integrated circuit on a wafer or on a printed circuit board, or for testing a wafer incorporating a plurality of micro circuits, comprising
a test head (19) incorporating a plurality of probes (18), each probe serving to contact one of a plurality of contact pads (22) of a micro circuit,
positioning means for positioning said test head or said pads relative to each other,
testing means (13) for testing the micro circuit via said probes of said test head, and
control means (11) for controlling said positioning means and said testing means, so that testing is performed according to the method of any one of the preceding claims.

11. The test system of claim 10, whereby said positioning means comprises first means for positioning said test head or said pads in a plane being substantially parallel to the plane comprising the pads of the micro circuit, and
second means for moving said test head or said pads in a direction substantially perpendicular to the plane comprising the pads of the micro circuit.

12. A test-system for testing a micro circuit (21), such as an integrated circuit on a wafer or on a printed circuit board, or for testing a wafer incorporating a plurality of micro circuits, comprising
a test head (19) incorporating a plurality of probes (18), each probe serving to contact one of a plurality of contact pads (22) of a micro circuit,
positioning means for positioning said test head or said pads relative to each other,
testing means (13) for testing the micro circuit via said probes of said test head, and
control means (11) for controlling said positioning means and said testing means, so that said test head or said pads can be made to move or vibrate by said positioning means in a plane being substantially parallel to a plane comprising the pads of the micro circuit after at least some of the probes are in mechanical contact with the corresponding pads.
